# EUROPEAN PATENT APPLICATION

(11) **EP 3 460 836 A1**
(43) Date of publication of application: **27.03.2019**
(21) Application number: 18158335.2
(22) Date of filing: 23.02.2018
(51) Int. Cl.: H01L 21/78, H01L 21/683

(54) **SEMICONDUCTOR DEVICE MANUFACTURING APPARATUS AND SEMICONDUCTOR DEVICE MANUFACTURING METHOD**

(30) Priority: 20.09.2017 JP 2017180636
(71) Applicant: Kabushiki Kaisha Toshiba, Minato-ku, Tokyo (JP); Toshiba Electronic Devices & Storage Corporation, Tokyo, 105-0023 (JP)
(72) Inventor: SHIOMI, Masahiko, Tokyo, 105-0023 (JP)
(74) Representative: Hoffmann Eitle

(57) **Abstract**

A semiconductor device manufacturing apparatus has a groove former configured to form a groove on one surface of a semiconductor wafer, on which a plurality of semiconductor devices is formed, to singulate the plurality of semiconductor devices; either a first heater configured to heat the groove; and a first cooler configured to cool the groove to cleave the semiconductor wafer at the groove after the groove has been heated by the first heater, or a second cooler configured to cool the semiconductor wafer; and a second heater configured to heat the groove to cleave the semiconductor wafer at the groove after the semiconductor wafer has been cooled by the second cooler.

## Description

### FIELD

Embodiments described herein relate to a semiconductor device manufacturing apparatus and a semiconductor device manufacturing method.

### BACKGROUND

Conventionally, there is a thermal cleaving process as a technique of cleaving a brittle material represented by glass. The thermal cleaving process is a process of forming a groove with a cutting tool on a brittle material such as glass, heating a groove portion with fire, and rapidly cooling with a cloth containing water to cleave the brittle material at a position of the groove.

With the capability of cleaving a semiconductor wafer on which a plurality of semiconductor devices is formed into individual semiconductor devices using this thermal cleaving process, it is possible to singulate a high-hardness semiconductor wafer with high performance, leading to achieving technical advantages.

### BRIEF DESCRIPTION OF THE DRAWINGS

FIG. 1 is a block diagram illustrating an exemplary configuration of a semiconductor device manufacturing apparatus according to a first embodiment;
FIG. 2 is a plan view of a semiconductor wafer on which a plurality of semiconductor devices to be singulated by thermal cleaving process according to the first and second embodiments is formed;
FIGS. 3A to 3D are illustrations of a manufacturing process of singulating a plurality of semiconductor devices from a semiconductor wafer on which the plurality of semiconductor devices is formed;
FIG. 4 is a flowchart illustrating semiconductor wafer cleaving processing according to the first embodiment.
FIG. 5 is a view illustrating processing of singulating a metal film together with a die bonding film formed on one surface of a semiconductor wafer and forming a groove on a semiconductor wafer;
FIG. 6 is a diagram illustrating a technique of forming a groove on a semiconductor wafer by a groove former of a semiconductor device manufacturing apparatus according to first and second embodiments;
FIG. 7 is a diagram illustrating a technique of cleaving a semiconductor wafer by heating and cooling a groove of the semiconductor wafer by a heater and a cooler of the semiconductor device manufacturing apparatus according to the first embodiment;
FIG. 8 is a block diagram illustrating an exemplary configuration of a semiconductor device manufacturing apparatus according to the second embodiment;
FIG. 9 is a flowchart illustrating semiconductor wafer cleaving processing according to the second embodiment;
FIG. 10 is a diagram illustrating a technique of cleaving a semiconductor wafer by cooling and heating a groove of the semiconductor wafer by a cooler and a heater of the semiconductor device manufacturing apparatus according to the second embodiment;
FIG. 11 is a diagram illustrating a modification of the semiconductor wafer cleaving processing according to the first embodiment; and
FIG. 12 is a diagram illustrating a modification of the semiconductor wafer cleaving processing according to the second embodiment.

### DETAILED DESCRIPTION

Hereinafter, a semiconductor device manufacturing apparatus and a semiconductor device manufacturing method according to the present embodiment will be described with reference to the drawings. In the following description, constituent elements having substantially the same function and configuration are denoted by the same reference numerals, and overlapping explanation will be given when necessary.

### (First Embodiment)

A semiconductor device manufacturing apparatus according to a first embodiment forms a groove for singulating a plurality of semiconductor devices on one surface of a semiconductor wafer on which the plurality of semiconductor devices is formed, and then heats the groove and thereafter cools the groove to cleave the semiconductor wafer at a position of the groove. The details will be described below.

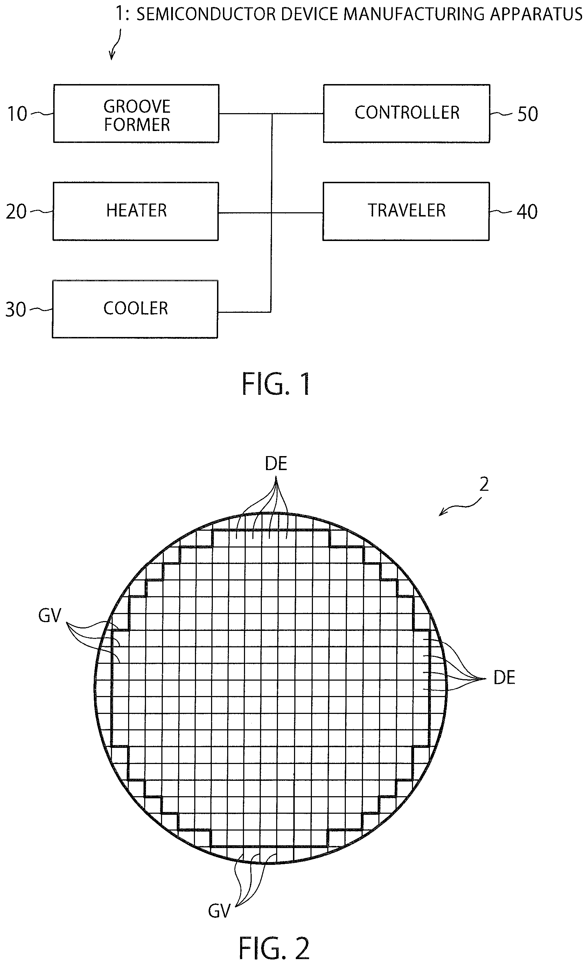

FIG. 1 is a block diagram illustrating a schematic configuration of a semiconductor device manufacturing apparatus 1 according to the present embodiment. FIG. 2 is a plan view illustrating an exemplary semiconductor wafer 2 to be cleaved by the semiconductor device manufacturing apparatus 1.

As illustrated in FIG. 1, the semiconductor device manufacturing apparatus 1 according to the present embodiment includes a groove former 10, a heater 20, a cooler 30, a traveler 40, and a controller 50. The semiconductor device manufacturing apparatus 1 is installed in a factory having a manufacturing process of forming a semiconductor device on the semiconductor wafer 2.

The groove former 10 is a unit for forming a groove on the semiconductor wafer 2 mounted on the traveler 40.

In the present embodiment, the groove former 10 includes a pulse laser emission apparatus to emit a pulse laser with a short wavelength or an electron beam emission apparatus to emit an electron beam, and emits a pulse laser or an electron beam to form a groove on the semiconductor wafer 2.

The groove former 10 also includes a spraying apparatus for spraying pure water or liquid nitrogen onto the semiconductor wafer 2. The pure water or liquid nitrogen is sprayed by the spraying apparatus to cool the semiconductor wafer 2 having the groove formed by a pulse laser or an electron beam.

The heater 20 is a unit to heat the groove of the semiconductor wafer 2 mounted on the traveler 40. In the present embodiment, the heater 20 includes a laser apparatus that emits a laser, for example. The laser apparatus emits the laser to the semiconductor wafer 2 to heat the groove.

The cooler 30 is a unit to cool the groove of the semiconductor wafer 2, mounted on the traveler 40. In the present embodiment, the cooler 30 includes a spraying apparatus for spraying liquid nitrogen, for example. The spraying apparatus sprays liquid nitrogen onto the semiconductor wafer 2 to cool the groove.

The traveler 40 is a unit on which the semiconductor wafer 2 as illustrated in FIG. 2 is mounted and configured to travel in a predetermined direction. This traveler includes a semiconductor wafer conveying apparatus to convey the semiconductor wafer 2 in a predetermined direction. The semiconductor wafer conveying apparatus moves in a predetermined direction in a state where the semiconductor wafer 2 is mounted on the apparatus, so as to cause the semiconductor wafer 2 to travel in the predetermined direction together.

The controller 50 is an apparatus that performs overall control of the semiconductor device manufacturing apparatus 1. In the present embodiment, the controller 50 controls operation of, in particular, the groove former 10, the heater 20, the cooler 30, and the traveler 40. The controller 50 may include a computer, for example, or may include a dedicated control apparatus having an ASIC and a storage apparatus.

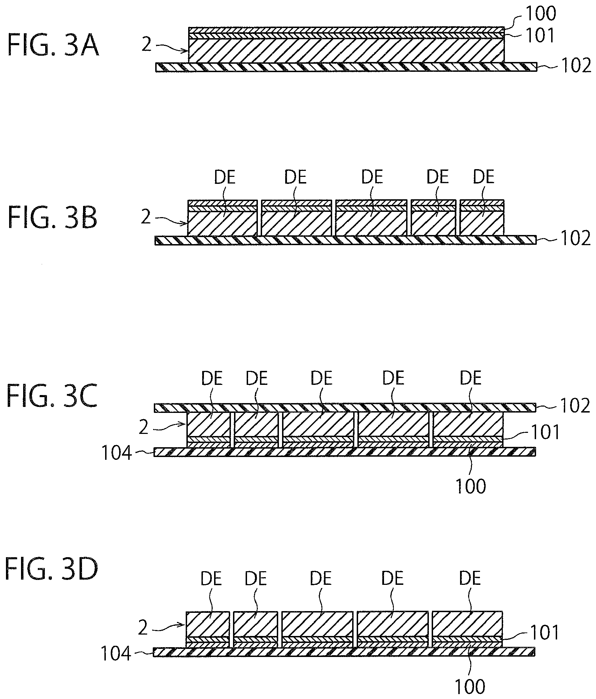

FIGS. 3A to 3D are illustrations of an exemplary manufacturing process of using the semiconductor device manufacturing apparatus 1 according to the present embodiment to singulate a plurality of semiconductor devices from the semiconductor wafer 2 on which the plurality of semiconductor devices is formed. FIGS. 3A to 3D are schematic cross-sectional views of the semiconductor wafer 2, in which the number of semiconductor devices is reduced from the number in the plan view of the semiconductor wafer 2 of FIG. 2 to facilitate understanding.

First, as illustrated in FIG. 3A, a die bonding film 100 is formed on the semiconductor wafer 2 according to the present embodiment. The die bonding film 100 is also referred to as a solder film. In the present embodiment, this die bonding film 100 is formed by sputtering or the like in a manufacturing process of forming a semiconductor device on the semiconductor wafer 2. Alternatively, it is possible to form the die bonding film 100 in an assembling step after the manufacturing process instead of in a portion of the manufacturing process of forming a semiconductor device on the semiconductor wafer 2. Still, forming the die bonding film 100 by sputtering or the like as a portion of the manufacturing process would enable advanced thinning of about 10 µm and control of maintaining a uniform film thickness with high accuracy.

Moreover, in the present embodiment, the die bonding film 100 is formed on one surface of the semiconductor wafer 2 via a metal film 101. That is, the metal film 101 is formed on the one surface of the semiconductor wafer 2, with the die bonding film 100 formed on the metal film 101. The metal film 101 is formed of a high melting point metal material, for example, and reduces an electric resistance between the semiconductor wafer 2 and the die bonding film 100.

A first sheet 102 having a first adhesion, that is, relatively weak in adhesion, is bonded to the surface of the semiconductor wafer 2 on which the die bonding film 100 is not formed. The first sheet 102 serves to prevent the semiconductor devices from coming loose at singulation of the plurality of semiconductor devices of the semiconductor wafer 2.

Next, as illustrated in FIG. 3B, the plurality of semiconductor devices formed on the semiconductor wafer 2 is singulated into individual semiconductor devices DE by semiconductor wafer cleaving processing. This processing separates the semiconductor devices DE to be independent from each other. In this state, the semiconductor devices DE do not come loose, however, since the first sheet 102 is bonded beforehand.

Next, as illustrated in FIG. 3C, a second sheet 104 having a second adhesion, relatively high adhesion, is bonded to the surface of the semiconductor wafer 2 on which the first sheet 102 is not bonded, that is, the surface on which the die bonding film 100 is formed. This second sheet 104 is a sheet used for assembling the semiconductor device DE.

Next, as illustrated in FIG. 3D, the first sheet 102 is peeled off from the semiconductor device DE. Therefore, the first adhesion of the first sheet 102 needs to be weaker than the second adhesion of the second sheet 104. Furthermore, the second adhesion of the second sheet 104 needs to be of a level that can be peeled off from the semiconductor device DE during the assembly process of the semiconductor device DE.

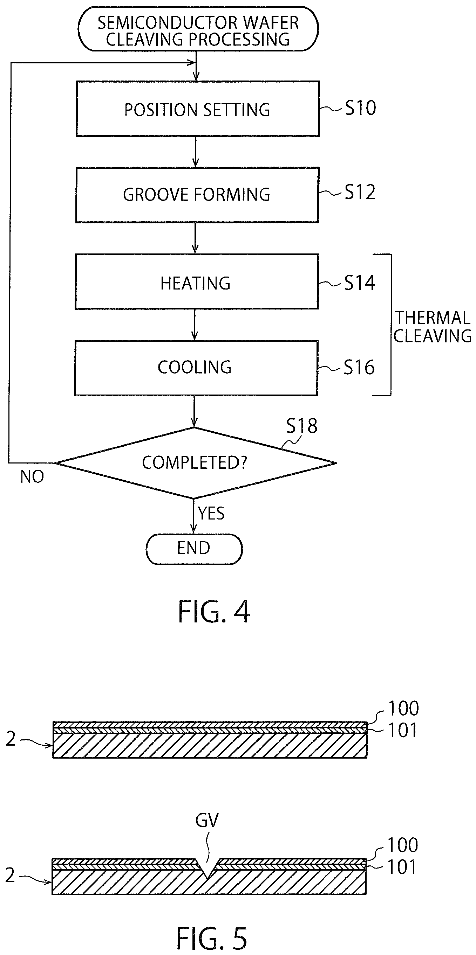

FIG. 4 is a flowchart illustrating details of the semiconductor wafer cleaving processing of FIG. 3B. This semiconductor wafer cleaving processing is processing controlled and executed by the controller 50 in the semiconductor device manufacturing apparatus 1 illustrated in FIG. 1. Hereinafter, the semiconductor wafer cleaving processing of FIG. 4 will be described with reference to FIGS. 1 and 2.

As illustrated in FIG. 4, the semiconductor device manufacturing apparatus 1 first mounts the semiconductor wafer 2 on the traveler 40 and sets the position of the semiconductor wafer 2 on the traveler 40 (step S10). For example, alignment marks are formed on the semiconductor wafer 2 in FIG. 2, and the semiconductor wafer 2 mounted on the traveler 40 is aligned on the basis of the alignment marks.

Next, as illustrated in FIG. 4, the groove former 10 of the semiconductor device manufacturing apparatus 1 forms grooves on the semiconductor wafer 2 (step S12). That is, as illustrated in FIG. 5, in order to singulate the semiconductor devices DE formed on the semiconductor wafer 2, the die bonding film 100 together with the metal film 101 are separated to form grooves GV on the semiconductor wafer 2.

As illustrated in FIG. 2, the grooves GV are formed in a grid pattern on the semiconductor wafer 2 in order to separate the individual semiconductor devices DE. Therefore, since the grooves GV are formed one by one in step S12 according to the present embodiment, the groove forming processing is also sequentially performed by the number of grooves GV. It is also possible, however, to simultaneously form a plurality of grooves GV on the surface of the semiconductor wafer 2, instead of one groove GV.

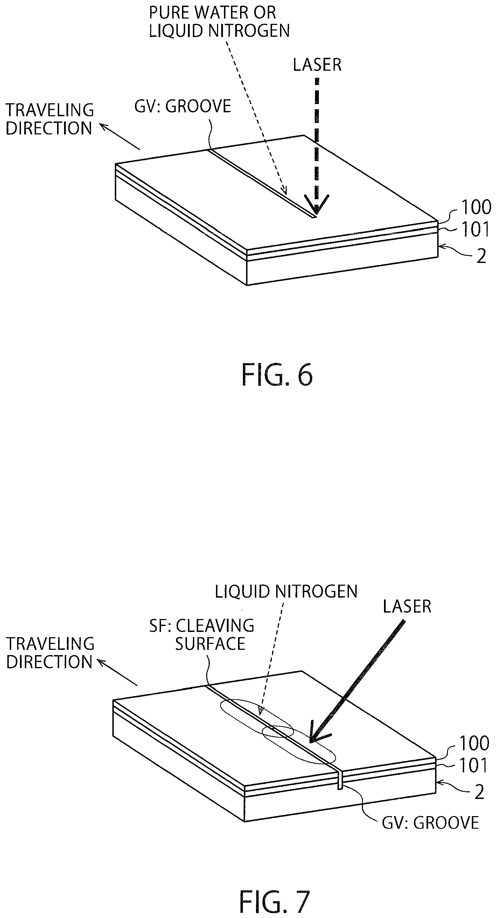

FIG. 6 is a diagram illustrating a technique of forming the groove GV on the semiconductor wafer 2 by the groove former 10 of the semiconductor device manufacturing apparatus 1 according to the present embodiment. As illustrated in FIG. 6, the groove former 10 emits a laser to separate the die bonding film 100 together with the metal film 101 along the individual semiconductor devices DE while forming the grooves GV on the semiconductor wafer 2. That is, singulation of the die bonding film 100 together with the metal film 101 and groove forming on the semiconductor wafer 2 are simultaneously performed by the laser. After the grooves are formed in the semiconductor wafer 2 by the laser, the groove former 10 performs spraying of pure water or liquid nitrogen to prevent melting of the die bonding film 100.

While the groove former 10 emits these lasers while spraying pure water or liquid nitrogen, the traveler 40 causes the semiconductor wafer 2 to travel in a traveling direction of FIG. 6, i.e. in an extending direction of the grooves GV to cleave the semiconductor wafer 2. This results in formation of the grooves GV for singulation along the individual semiconductor device DE.

Next, as illustrated in FIG. 4, the heater 20 of the semiconductor device manufacturing apparatus 1 heats the groove GV (step S14), and thereafter, the cooler 30 cools the groove GV so as to cleave the semiconductor wafer 2 at the groove GV (step S16). This cleaving is a technology referred to as thermal cleaving, in which the material is cleaved by thermal shock caused by a rapid temperature change.

FIG. 7 is a diagram illustrating a technique of cleaving the semiconductor wafer 2 by heating and cooling the groove GV of the semiconductor wafer 2 by the heater 20 and the cooler 30 of the semiconductor device manufacturing apparatus 1 according to the present embodiment.

As illustrated in FIG. 7, the heater 20 emits the laser to heat the groove GV, and immediately after this, the cooler 30 sprays liquid nitrogen to cool the groove GV.

In the present embodiment, the semiconductor wafer 2 is formed of SiC, for example, a type of a brittle material. While the thermal shock resistance of SiC is a temperature difference of 450°C, the thermal shock resistance at the groove GV is lowered to 365°C or less because the stress concentrates on the groove GV by the groove forming in step S12. Therefore, in the present embodiment, the groove GV is heated up to 180°C by laser emission by the heater 20, for example. The die bonding film 100 does not melt at this temperature of 180°C. Following the heating of the groove GV by the heater 20, the cooler 30 cools the groove GV down to -186°C by spraying liquid nitrogen.

This makes the temperature difference 180°C + 186°C = 366°C, which exceeds the thermal shock resistance temperature of 365°C. This makes it possible to cleave the semiconductor wafer 2 at the groove GV. Note that the temperature 180°C generated by laser emission by the heater 20 corresponds to a first temperature according to the present embodiment, and the temperature -186°C generated by the spraying of liquid nitrogen by the cooler 30 corresponds to a second temperature according to the present embodiment.

As can be seen from this, the shorter the time after heating by the heater 20 before cooling by the cooler 30, the better. This is because the temperature of the grooves GV heated by the laser emission decreases with the lapse of time, making it difficult to form the temperature difference needed for the thermal cleaving with the cooling by the cooler 30. Moreover, heat transfer by nucleate boiling is occurring when the liquid nitrogen is sprayed by the cooler 30, making it possible to rapidly cool the semiconductor wafer 2.

Incidentally, the thermal shock resistance temperature is an index which indicates how much rapid temperature change the material can absorb, and it shows that the material can absorb bigger temperature change as its value is bigger. One of examples of the materials which form the semiconductor wafer 2 in the present embodiment is SiC, and it can absorb a temperature difference of 450°C or less but a crack will be made by the temperature difference more than that. In the present embodiment, the thermal shock resistance is lowered to 365°C or less by the stress concentration to the groove GV in order to cleave the semiconductor wafer 2 at the groove GV.

For instance, the Japanese Industrial Standards (JIS) 1648 defines a test method to evaluate a thermal shock resistance of fine ceramic. In the present embodiment, in compliance with the test method defined by the JIS 1648, a groove GV has been formed between two chips and a cross sectional shape of the groove GV has been adjusted so that a temperature to make a crack at the groove GV is 365°C or less.

In the present embodiment, the semiconductor wafer 2 travels in the traveling direction by the traveler 40 while heating by the heater 20 and cooling by the cooler 30 is performed onto the groove GV. Therefore, the semiconductor wafer 2 is sequentially cleaved along the groove GV, to form a cleaving surface SF. This cleaving is performed toward all the grooves GV formed on the semiconductor wafer 2 in FIG. 2, so as to complete steps S14 and S16. With this procedure, the plurality of semiconductor devices DE formed on the semiconductor wafer 2 are separated from each other to be singulated.

Next, as illustrated in FIG. 4, the controller 50 of the semiconductor device manufacturing apparatus 1 judges whether the cleaving processing for all the prepared semiconductor wafers 2 has been completed (step S18). In a case where the cleaving processing of all the semiconductor wafers 2 has not been completed (step S18: No), the next semiconductor wafer 2 is mounted on the traveler 40 to repeat the processing from the position setting of the above-described step S10. In contrast, in a case where the cleaving processing for all the semiconductor wafers 2 is completed, the semiconductor wafer cleaving processing illustrated in FIG. 4 is finished.

As described above, with the semiconductor device manufacturing apparatus 1 according to the present embodiment, the groove GV for singulating the plurality of semiconductor devices DE is formed on one side of the semiconductor wafer 2, and the groove GV is heated by the heater 20 and then cooled by the cooler 30 so as to cleave the semiconductor wafer 2 at the groove GV. Accordingly, it is possible to cleave the high-hardness semiconductor wafer 2 to singulate into individual semiconductor devices DE by the thermal cleaving process.

Moreover, by thermally cleaving the semiconductor wafer 2 by the temperature difference in this manner, it is possible to singulate the plurality of semiconductor devices DE formed on the semiconductor wafer 2 with high quality and with high accuracy. Furthermore, it is possible to achieve higher performance than in semiconductor wafer 2 cutting processing using a conventional dicing saw, leading to higher throughput.

### (Second Embodiment)

While the first embodiment described above performs a thermal cleaving process in which the groove GV formed in the semiconductor wafer 2 is heated by the heater 20 and thereafter is cooled by the cooler 30 so as to cleave the semiconductor wafer 2 at the groove GV, the present embodiment performs the thermal cleaving process in which the grooves GV are first cooled and then heated to cleave the semiconductor wafer 2 at the grooves GV using the temperature difference. Hereinafter, portions different from the above-described first embodiment will be described.

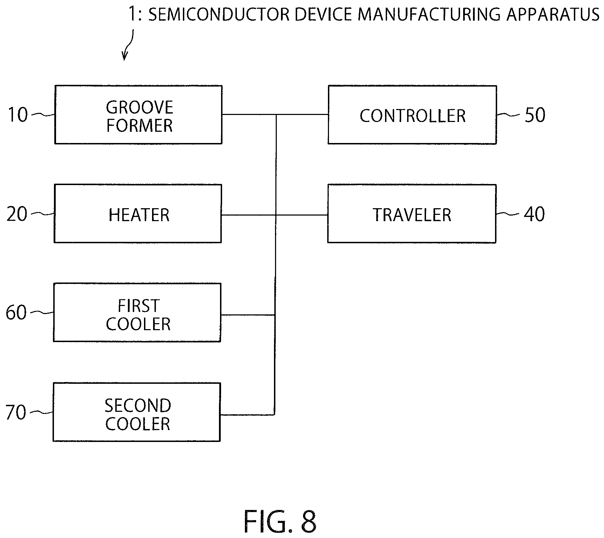

FIG. 8 is a block diagram illustrating a configuration of the semiconductor device manufacturing apparatus 1 according to the present embodiment, and corresponds to FIG. 1 in the above-described first embodiment. As illustrated in FIG. 8, the semiconductor device manufacturing apparatus 1 according to the present embodiment includes a first cooler 60 and a second cooler 70 in place of the cooler 30.

The first cooler 60 includes a cooling apparatus to cool the semiconductor wafer 2 as a whole and has a capability of cooling the semiconductor wafer 2 down to -186°C using liquid nitrogen in the present embodiment. The second cooler 70 includes a cooling apparatus for additionally cooling the grooves GV formed on the semiconductor wafer 2, and includes a spraying apparatus for spraying liquid nitrogen, for example. The other configuration is similar to the configuration of the semiconductor device manufacturing apparatus 1 according to the above-described first embodiment.

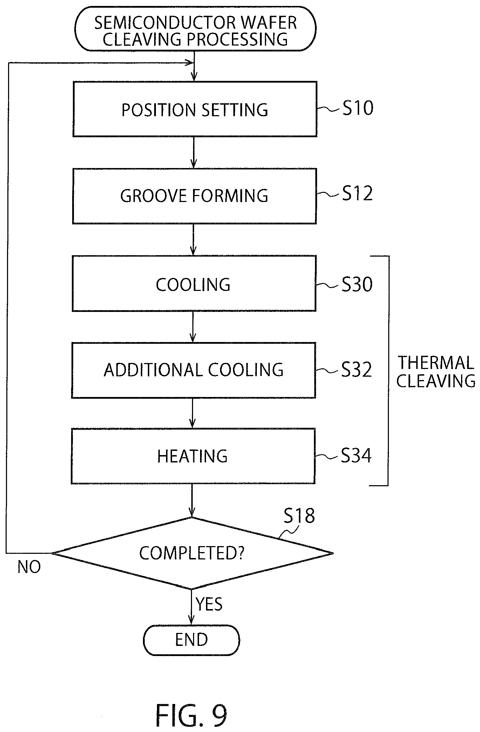

FIG. 9 is a flowchart illustrating details of the semiconductor wafer cleaving processing according to the present embodiment and corresponds to FIG. 4 in the above-described first embodiment. As illustrated in FIG. 9, the semiconductor wafer cleaving processing according to the present embodiment is similar to the above-described first embodiment up to the position setting in step S10 and up to the groove forming in step S12.

After this groove forming processing (step S12), the first cooler 60 of the semiconductor device manufacturing apparatus 1 performs overall cooling of the semiconductor wafer 2 (step S30) in the present embodiment.

In the present embodiment, the semiconductor wafer 2 is cooled down to -186°C by the cooling by the first cooler 60.

Next, as illustrated in FIG. 9, the second cooler 70 of the semiconductor device manufacturing apparatus 1 additionally cools the groove GV of the semiconductor wafer 2 to maintain the temperature of the groove GV at -186°C (step S32). Subsequently, the heater 20 of the semiconductor device manufacturing apparatus 1 heats the groove GV (step S34). In the present embodiment, heating is performed up to 180°C by heating with a laser. This processing forms a temperature difference 366°C (186°C + 180°C) that exceeds the thermal shock resistance to thermally cleave the semiconductor wafer 2 at the groove GV.

Similarly to the first embodiment, this thermal cleaving process is performed along the groove GV while conveying the semiconductor wafer 2 in a direction for conveying the semiconductor wafer 2 by the traveler 40, i.e. an extending direction of the groove GV to cleave the semiconductor wafer 2. The all the grooves GV of the semiconductor wafer 2 mounted on the traveler 40 are thermally cleaved and thereafter singulation of the plurality of semiconductor devices DE formed on the semiconductor wafer 2 is completed, then, it is judged whether the thermal cleaving of all the prepared semiconductor wafers 2 has been completed (step S18) similarly to the first embodiment.

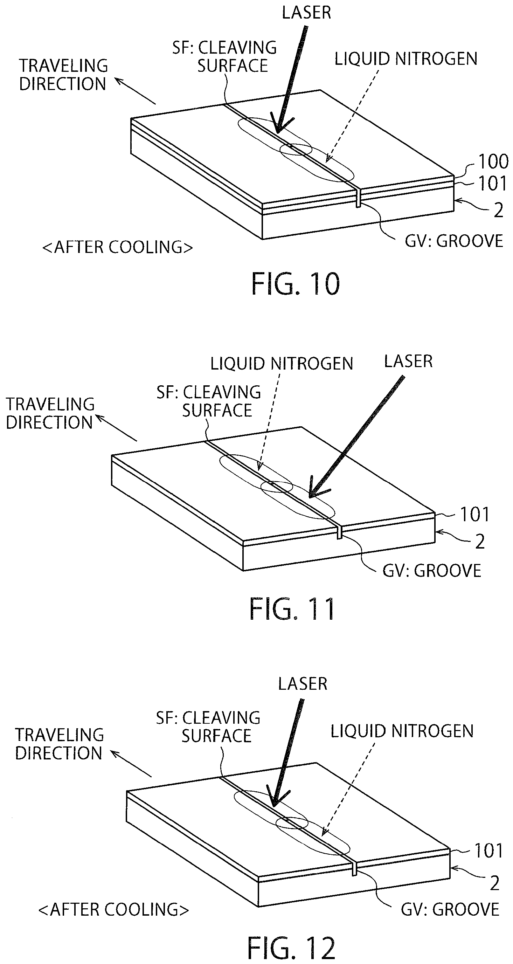

FIG. 10 illustrates a technique in which the first cooler 60 and the second cooler 70 of the semiconductor device manufacturing apparatus 1 in the present embodiment cool the semiconductor wafer 2, and immediately thereafter, the heater 20 heats the semiconductor wafer 2 so as to perform thermal cleaving at the groove GV.

As illustrated in FIG. 10, the first cooler 60 cools the semiconductor wafer 2 as a whole down to -186°C with liquid nitrogen. Next, the second cooler 70 additionally cools the groove GV formed on the semiconductor wafer 2 and to maintain the temperature at -186°C. Then, the heater 20 heats the groove GV up to 180°C by laser emission. Since the groove GV is formed, the stress concentrates in the groove GV, and the semiconductor wafer 2 formed of SiC as a type of brittle material can be cleaved at the position of the groove GV. Note that the procedure in which the second cooler 70 cools the semiconductor wafer 2, and immediately thereafter, the traveler 40 causes the semiconductor wafer 2 to travel while the heater 20 heats the semiconductor wafer 2 to continuously perform cooling and heating along the groove GV is similar to the case of the above-described first embodiment.

As described above, also in the semiconductor device manufacturing apparatus 1 according to the present embodiment, the groove GV for singulating the plurality of semiconductor devices DE is formed on one side of the semiconductor wafer 2, and then the groove GV is cooled by the first cooler 60 beforehand and thereafter additionally cooled by the second cooler 70 and then is heated by the heater 20, whereby the semiconductor wafer 2 is cleaved at the groove GV. Accordingly, it is possible to cleave the high-hardness semiconductor wafer 2 to singulate into individual semiconductor devices DE by the thermal cleaving process.

Incidentally, in the present embodiment, if the first cooler 60 can cool the semiconductor wafer 2 sufficiently and the semiconductor wafer 2 cooled at -186°C can be kept, the second cooler 70 may be omitted.

### (Modification of First Embodiment and Second Embodiment)

In the first and the second embodiments described above, the die bonding film 100 is formed on one surface of the semiconductor wafer 2. Alternatively, however, the die bonding film 100 need not be formed during in thermal cleaving process. That is, in the first embodiment, as illustrated in FIG. 11, it is allowable to form the groove GV on one surface of the semiconductor wafer 2 on which the die bonding film 100 is not formed, the groove GV is first heated by the heater 20 and then the groove GV is cooled by the cooler 30 to perform thermal cleaving.

In the second embodiment, as illustrated in FIG. 12, it is allowable to form the groove GV on one surface of the semiconductor wafer 2 on which the die bonding film 100 is not formed, cool the semiconductor wafer 2 as a whole by the first cooler 60 then additionally cool the groove GV by the second cooler 70, and thereafter, heat the groove GV by the heater 20 to perform thermal cleaving. In these cases, the metal film 101 may be formed on one side of the semiconductor wafer 2 or may omit formation of this.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

For example, in the above-described embodiments, SiC is exemplified as a brittle material to form the semiconductor wafer 2. Alternatively, however, it is also possible to form the semiconductor wafer 2 with another brittle material such as GaN and then apply the thermal cleaving process in the above-described embodiments to cleave the semiconductor wafer 2.

## Claims

1. A semiconductor device manufacturing apparatus comprising:
a groove former configured to form a groove on one surface of a semiconductor wafer, on which a plurality of semiconductor devices is formed, to singulate the plurality of semiconductor devices;
either
a first heater configured to heat the groove; and
a first cooler configured to cool the groove to cleave the semiconductor wafer at the groove after the groove has been heated by the first heater,
or
a second cooler configured to cool the semiconductor wafer; and
a second heater configured to heat the groove to cleave the semiconductor wafer at the groove after the semiconductor wafer has been cooled by the second cooler.

2. The semiconductor device manufacturing apparatus according to claim 1,
wherein the first heater heats the groove at a first temperature,
the first cooler cools the groove at a second temperature, and
a temperature difference between the first temperature and the second temperature exceeds a thermal shock resistance in the groove of the semiconductor wafer.

3. The semiconductor device manufacturing apparatus according to claim 1 or 2,
wherein a metal film is formed on the one surface of the semiconductor wafer,
a die bonding film is formed on the metal film, and
the groove former singulates the die bonding film and the metal film at the time of forming the groove.

4. The semiconductor device manufacturing apparatus according to one of claims 1-3, wherein the first cooler uses liquid nitrogen to cool the groove.

5. The semiconductor device manufacturing apparatus according to one of claims 1-4, wherein the first heater uses a laser to heat the groove.

6. The semiconductor device manufacturing apparatus according to one of claims 1-5,
wherein the first heater performs heating along the groove, and
the first cooler performs cooling following the heating performed by the first heater.

7. The semiconductor device manufacturing apparatus according to claim 6, further comprising
a traveler configured to cause the semiconductor wafer to travel along an extending direction of the groove to cleave the semiconductor wafer,
wherein the semiconductor wafer travels along the extending direction of the groove by the traveler, and both a position at which the groove is heated by the first heater and a position at which the groove is cooled by the first cooler travel along the extending direction of the groove together with the traveling of the semiconductor wafer.

8. The semiconductor device manufacturing apparatus according to claim 1,
wherein the second heater heats the groove at a first temperature,
the second cooler cools the semiconductor wafer at a second temperature, and
a temperature difference between the first temperature and the second temperature exceeds a thermal shock resistance in the groove of the semiconductor wafer.

9. The semiconductor device manufacturing apparatus according to claim 1 or 8, further comprising a third cooler configured to additionally cool the groove after the semiconductor wafer has been cooled by the second cooler.

10. The semiconductor device manufacturing apparatus according to claim 9, wherein the third cooler cools the groove also at the second temperature.

11. The semiconductor device manufacturing apparatus according to one of claims 1 and 8-10, wherein the second cooler uses liquid nitrogen to cool the semiconductor wafer.

12. The semiconductor device manufacturing apparatus according to one of claims 1 and 8-11, wherein the second heater uses a laser to heat the groove.

13. The semiconductor device manufacturing apparatus according to claim 9,
wherein the second cooler performs cooling the semiconductor wafer as a whole;
the third cooler performs cooling along the groove; and
the second heater performs heating along the groove following the cooling performed by the third cooler.

14. The semiconductor device manufacturing apparatus according to claim 13, further comprising
a traveler configured to cause the semiconductor wafer to travel along an extending direction of the groove to cleave the semiconductor wafer,
wherein the semiconductor wafer travels along the extending direction of the groove by the traveler, and both a position at which the groove is cooled by the third cooler and a position at which the groove is heated by the second heater travel along the extending direction of the groove together with the traveling of the semiconductor wafer.

15. A semiconductor device manufacturing method comprising:
forming a groove on one surface of a semiconductor wafer, on which the plurality of semiconductor devices is formed, to singulate a plurality of semiconductor devices;
either
heating the groove; and
cooling the groove after the groove has been heated and cleaving the semiconductor wafer at the groove,
or
cooling the semiconductor wafer; and
heating the groove to cleave the semiconductor wafer at the groove after the semiconductor wafer has been cooled.
